# EUROPÄISCHE PATENTSCHRIFT

(11) **EP 2 815 245 B1**
(45) Veröffentlichungstag und Bekanntmachung des Hinweises auf die Patenterteilung: **25.04.2018**
(21) Anmeldenummer: 12710880.1
(22) Anmeldetag: 18.02.2012
(51) Int. Cl.: G01R 31/14

(54) **SCHALTUNGSANORDNUNG ZUR ERZEUGUNG EINER PRÜFSPANNUNG INSBESONDERE ZUR ISOLATIONSPRÜFUNG VON VERLEGTEN ENERGIEKABELN**
CIRCUIT ARRANGEMENT FOR GENERATING A TEST VOLTAGE, IN PARTICULAR FOR TESTING THE INSULATION OF INSTALLED CABLE
ENSEMBLE DE CIRCUITS SERVANT À GÉNÉRER UNE TENSION DE CONTRÔLE, EN PARTICULIER POUR LE CONTRÔLE DE L'ISOLATION DE CÂBLES D'ÉNERGIE INSTALLÉS

(43) Veröffentlichungstag der Anmeldung: 24.12.2014
(73) Patentinhaber: BAUR GmbH, 6832 Sulz (AT)
(72) Erfinder: REKERS, Philipp, 48488 Emsbüren (DE)
(74) Vertreter: Hofmann, Ralf U.
(86) Internationale Anmeldenummer: PCT/EP2012/052821
(87) Internationale Veröffentlichungsnummer: WO 2013/120539

(56) Entgegenhaltungen:
- DE-A1- 3 737 373
- DE-C5- 19 513 441
- MANLI HU ET AL: "Frequency / duty cycle control of LCC resonant converter supplying high voltage very low frequency test systems", 13TH EUROPEAN CONFERENCE ON POWER ELECTRONICS AND APPLICATIONS, 2009 : EPE '09 ; 8 - 10 SEPT. 2009, BARCELONA, SPAIN, IEEE, PISCATAWAY, NJ, USA, 8. September 2009 (2009-09-08), Seiten 1-10, XP031541800, ISBN: 978-1-4244-4432-8 in der Anmeldung erwähnt

## Beschreibung

Die Erfindung betrifft eine Schaltungsanordnung zur Erzeugung einer Prüfspannung für die Prüfung elektrischer Betriebsmittel, umfassend Wechselspannungsquelle oder - alternativ - eine Spannungsquelle mit konstanter oder im wesentlichen konstanter Spannung und einem mit dieser verbundenen Schaltungsmittel zur Erzeugung einer vorzugsweise niederfrequenten Wechselspannung, eine mit der Wechselspannungsquelle gemäß einer der Alternativen verbundene Transformatoreinrichtung zur Erzeugung einer Hochspannung, ein insbesondere kaskadiert und/oder mehrstufig ausgeführtes Gleichrichterschaltungsmittel zur Umwandlung der Hochspannung in eine Gleichspannung veränderbarer Amplitude und eine Schaltungseinrichtung zum Aufladen des Prüflings mit der Gleichspannung und zum Entladen des Prüflings.

Mit derartigen Schaltungseinrichtungen erzeugte Prüfspannungen dienen zur Prüfung der Isolation elektrischer Betriebsmittel allgemein, insbesondere aber zur Prüfung von verlegten Energiekabeln. Der meist kapazitive Prüfling wird dabei in einer Periode jeweils auf die maximale positive und negative Spitzenprüfspannung aufgeladen.

Eine aus der DE 195 13 441 C5 bekannte Schaltungsanordnung der eingangs genannten Art wird bei Prüfgeneratoren eingesetzt, die vom sogenannten VLF (Very Low Frequency) - Typ sind. Zu größeren Prüfspannungen hin wirkt sich das durch die Baugruppen bestimmte zunehmend größere Volumen - und auch Gewicht - des Hochspannungskessels nachteilig aus. Ebenso nimmt die Baugröße auch bei den Gleichrichtern und Vervielfachern, noch mehr bei der Schaltungseinrichtung für das Aufladen und Entladen des Prüflings zu, die jeweils gegenseitig für die volle Betriebsspannung isoliert sein müssen. Des Weiteren ist der Kaskadierung und damit der Höhe der Prüfspannung eine Grenze durch Bauteil- und parasitäre Kapazitäten gesetzt. So begrenzen insbesondere auch die der Kaskade nachgeschalteten Teile im Abregelelement die Kaskadierung. Außerdem wird auch die im Prüfling gespeicherte Energie in Wärme umgewandelt. Bei Prüflingen hoher Kapazität oder hoher Prüfspannung wird eine aufwändige Kühlung benötigt.

Aus der WO 2009/143544 A2 ist ein VLF-Prüfgenerator bekannt, der einen Resonanzkreis mit zwei geringfügig differierenden Oszillatoren zur Erzeugung einer tieffrequenten Modulation umfasst, welcher eine Ausgangsspannung mit sehr hoher Amplitude und sehr niedriger Frequenz erzeugt. Da der Demodulator in der Lage sein muss, die doppelte Ausgangsspannung zu sperren, ist sein Aufbau komplex. Aufgrund seines geringen Gewichts dient der Prüfgenerator insbesondere zum transportablen Einsatz bei Isolationsprüfungen z.B. von erdverlegten Energiekabeln.

Gegentakt-Wandler finden bei getakteten Schaltreglern vorteilhaft bei Leistungen über 100 W Einsatz. Derartige Schaltnetzteile werden - z.B. in der Ausführung als Royer-Konverter - vielfach zur Versorgung von VFD (Vakuum-Fluoreszenz) -Displays eingesetzt.

Für höhere Prüfspannungen wurden gemäß dem in 13th European Conference and Applications (EPE2009), Barcelona, Spanien 2009 veröffentlichten Bericht "Frequency / Duty Cycle Control of LCC Resonant Converter Supplying High Voltage Very Low Frequency Test Systems" von M. Hu et al. neue VLF-Prüfgeneratoren entwickelt, die mit einer Prüfspannung von 0,1 Hz / 85 kV (RMS) arbeiten. Für die Erzeugung der Prüfhochspannung werden ein Vollbrücken-LCC-Resonanzwandler und ein Transformator sowie ein Cockcroft-Walton (CW)-Spannungsvervielfacher eingesetzt und die erzeugte Sinusspannung dann auf das zu prüfende Kabel und eine Kontrolleinheit für den Entladevorgang der Prüfspannung, d.h. einen variablen Widerstand, gegeben. Die Kontrolleinheit ist in Form einer Kaskade von Bipolartransistoren (IGBT) implementiert, die parallel zu einer Reihenschaltung von Hochspannungswiderständen, jeweils ein Transistor pro Widerstand, geschaltet sind.

Der Erfindung liegt die Aufgabe zugrunde, eine Schaltungsanordnung zur Erzeugung einer Prüfspannung für die Prüfung elektrischer Betriebsmittel zu schaffen, die einen vergleichsweise geringen Raumbedarf und geringes Gewicht hat sowie sich durch geringe Energieverluste auszeichnet.

Diese Aufgabe ist durch die Erfindung bei einer Schaltungsanordnung mit den Merkmalen des Anspruchs 1 gelöst. Vorteilhafte Weiterbildungen sind Gegenstand der Unteransprüche.

Eine Schaltungsanordnung zur Erzeugung einer Prüfspannung für die Prüfung elektrischer Betriebsmittel gemäß der Erfindung umfasst somit eine Wechselspannungsquelle oder eine Spannungsquelle mit konstanter oder im wesentlichen konstanter Spannung und einem mit der Spannungsquelle verbundenen Schaltungsmittel zur Erzeugung einer vorzugsweise niederfrequenten Wechselspannung U0. Mit der Wechselspannungsquelle ist ein vorzugsweise als Resonanznetzwerk ausgeführter Wechselrichter verbunden. Eine mit dem Wechselrichter verbundene Transformatoreinrichtung dient zur Erzeugung einer Hochspannung UT und eine insbesondere kaskadiert und/oder mehrstufig ausgeführtes Gleichrichterschaltungsmittel zur Umwandlung der Hochspannung in eine Gleichspannung UHV veränderbarer Amplitude. Des Weiteren ist eine Schaltungseinrichtung zum Aufladen des Prüflings mit der Gleichspannung UHV und zum Entladen des Prüflings vorgesehen. Auf der Eingangsseite ist der Wechselrichter mit (n) Schaltelementen ausgeführt, und auf der Ausgangsseite umfasst der Wechselrichter mehrere (k) Stufen. Der Ausgang des Wechselrichters ist mit der Schaltungseinrichtung zum Aufladen und Entladen des Prüflings verbunden. Das Gleichrichterschaltungsmittel ist als Wechselrichterschaltung für das Entladen des Prüflings kombiniert ausgeführt, deren Schalter auch als Ventile schaltbar sind, die den Stromfluss nur in eine Richtung ermöglichen.

Durch das Konzept des bidirektionalen und bipolaren Wechselrichters kann die Anzahl der in der Schaltungsanordnung verwendeten Baugruppen gegenüber dem beschriebenen herkömmlichen Aufbau herabgesetzt werden. Statt zwei Hochspannungstransformatoren und zwei Gleichrichter- und Vervielfacherschaltungen ist es möglich, nur einen Transformator und einen bidirektional und bipolar arbeitenden Wechselrichter zu verwenden, was sich beim Gewicht des Prüfspannungsgenerators vorteilhaft auswirkt. Beispielsweise kann eine Gewichtsreduktion eines Prüfspannungsgenerators um ca. 30% erzielt werden.

Die Realisierung der erfindungsgemäßen Schaltungsanordnung besteht vorzugsweise in dem Einsatz mehrerer Wechselrichter, die gemäß üblichem Schaltungsaufbau vorteilhaft als Halbbrücken-Gegentaktwandler primär- und sekundärseitig kapazitiv gekoppelt sind.

Durch das Vorsehen mehrerer Stufen auf der Ausgangsseite des Wechselrichters kann die Ausgangsspannung des Transformators für die einzelnen Stufen jeweils auf einen Bruchteil der Eingangsspannung herabgesetzt werden, so dass die Schalter dann auch nur diese Teilspannung schalten müssen. Diese Kaskadenbauweise ermöglicht es, mit der erfindungsgemäßen Schaltungsanordnung höhere Prüfspannungen einzusetzen, und die Bauteile werden weniger belastet.

Bei der erfindungsgemäßen Schaltungsanordnung gibt es zwei Betriebsmodi:
a) Energie wird dem Stromnetz entzogen und dem Prüfling zugeführt;
b) Energie wird dem Prüfling entzogen und dem Stromnetz zugeführt. Alternativ zum Stromnetz kann auch ein anderer Energiespeicher genutzt werden, dem lediglich während des Betriebs die Verlustleistung der Anordnung zugeführt werden muss.

Im Betriebsmodus a) wird eine Gleichspannungsquelle benutzt oder eine Gleichspannung bereitgestellt und die Gleichspannung in eine Rechteckspannung mit variabler Frequenz und je nach Auslegung variabler Pulsbreite generiert, vorzugsweise mit sehr niederer Frequenz (z.B. 20 bis 200 kHz). Die Rechteckform ist bevorzugt, aber nicht notwendig. Die Spannung des Transformators ist daher stufenförmig, wobei bei entsprechender Schaltungsausgestaltung durch das Resonanznetzwerk ein sinusförmiger Strom eingeprägt wird. In der Kaskadenanordnung wird die Spannung gleichgerichtet und kann durch Änderung von Pulsbreite und Frequenz am Eingang variiert werden, womit die langsam variierende Gleichspannung bzw. langsame Wechselspannung (Frequenz kleiner als Schaltfrequenz von Halb- oder Vollbrücke) generiert wird.

Im Betriebsmodus b) wird die Hochspannung am Prüfling abgebaut und die in Form einer geladenen Kapazität gespeicherte Energie in eine niedrigere Spannung umgewandelt, wieder der erfindungsgemäßen Schaltungsanordnung zugeführt und für den nächsten Ladevorgang zwischengespeichert oder in das Stromnetz eingespeist.

Durch diese Möglichkeit der Energierückgewinnung ist der Wirkungsgrad der erfindungsgemäßen Schaltungsanordnung gegenüber herkömmlichen Schaltungsanordnungen verbessert. Es wird Energie gespart und es entsteht keine bzw. deutlich weniger Verlustwärme. Dies erleichtert die Konstruktion und die Baugröße kann kleiner gewählt werden.

Bei einer Ausführungsform der erfindungsgemäßen Schaltungsanordnung sind die ausgangsseitigen Stufen des Wechselrichters mit einer aktiven Spannungsbegrenzung, weiterhin vorteilhaft auch mit einem Überspannungsschutz versehen.

Durch die Kombination der Gleichrichterschaltung mit einer Wechselrichterschaltung kann dieselbe Anordnung zum Laden und Entladen des Prüflings verwendet werden. Dies ist für die Reduktion der Baugröße ein wichtiger Aspekt.

Zu dem Zweck einer gleichmäßigen Spannungsaufteilung sind die ausgangsseitigen Stufen des Wechselrichters vorzugsweise symmetriert ausgeführt.

Vorteilhaft weisen die ausgangsseitigen Stufen des Wechselrichters eine Lichtsteuerung auf, die beispielsweise mittels Photodioden realisiert ist.

Bei einer Ausführung der erfindungsgemäßen Schaltungsanordnung ist ein Schalter für eine der ausgangsseitigen k Stufen des Wechselrichters k-stufig ausgeführt, wobei für jeden Schalter 2k Ansteuerungen vorgesehen sind. Bei anderen Ausführungen kann z.B. eine induktive Ansteuerung verwendet werden.

Vorzugsweise ist der Wechselrichter als Resonanzwandler ausgeführt. Durch die nahezu sinusförmigen Signalverläufe können die Bauteile synchron angesteuert werden und eine Umpolung auch von sich ergebenden parasitären Kapazitäten ist sichergestellt.

Eine Ausführung eines solchen Resonanzwandlers kann als LLC-, LCC- oder LCL-Konverter vorgesehen sein, der eine geringe Verlustleistung hat und einen guten Wirkungsgrad sicherstellt. Vorteilhaft wird für das Aufladen ein LCC-Resonanzkreis und für das Rückspeisen ein LLC-Resonanzkreis eingesetzt, zwischen denen durch ein Schaltelement umgeschaltet wird. Durch den integrierten Resonanzwandler kann ein nahezu sinusförmiger Strom erzeugt werden und induktive Blindleistung zum Erreichen des Nullspannungsschaltens, insbesondere der Hochspannungsschalter, bereitgestellt werden. Andernfalls kommt es zu starkem Anstieg der Verluste und entsprechender Verringerung des Wirkungsgrads. Dabei kann die Spannungsbeanspruchung geringer gehalten werden, wodurch Bauteile kleiner ausgelegt werden können und die Leitungsverluste geringer sind.

Die Erfindung wird im Folgenden weiter anhand von Ausführungsbeispielen und der Zeichnung beschrieben. Diese Darstellung dient lediglich zu Veranschaulichungszwecken und soll die Erfindung nicht auf die konkret angegebenen Merkmalskombinationen einschränken. Es zeigen
- Fig. 1: ein Blockschaltbild eines Ausführungsbeispiels einer Schaltungsanordnung gemäß der Erfindung in der Ausführung als zweistufiger Kaskadenwandler mit integriertem Resonanzwandler;
- Fig. 2: ein schematisches Diagramm, das den Spannungsverlauf an den Punkten A, B und C in Fig. 1 in Abhängigkeit von der Zeit zeigt; und
- Fig. 3: ein Beispiel eines bei der erfindungsgemäßen Schaltungsanordnung verwendeten Vollbrücken-Gegentaktwandlers.

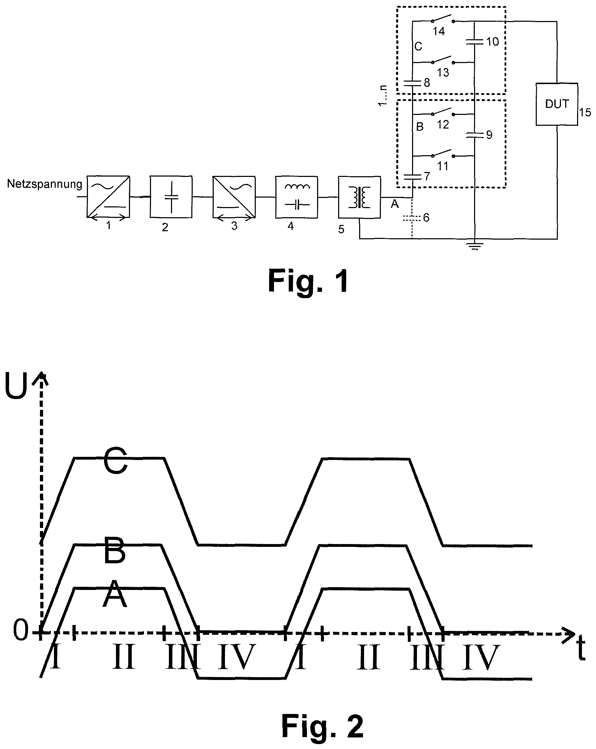

Fig. 1 zeigt ein Blockschaltbild einer gemäß der Erfindung aufgebauten Schaltungsanordnung. Diese umfasst einen Netzgleichrichter 1, einen Zwischenkreis 2, einen Wechselrichter 3, ein Resonanznetzwerk (Resonanzwandler) 4, einen Hochspannungstransformator 5. Mit 6 ist eine Ersatzkapazität bezeichnet, die die parasitären Kapazitäten des Hochspannungsaufbaus zusammenfasst. Die Bezugszeichen 7 bis 10 repräsentieren einen Kaskaden-Gleich-/Wechselrichter mit einer Schubsäule (Kondensatoren 7, 8) und einer Glättungssäule (Kondensatoren 9, 10). Es sind Hochspannungsschalter 11 bis 14 vorgesehen. Der Prüfling ist mit dem Bezugszeichen 15 bezeichnet.

Der Netzgleichrichter 1 kann passiv als Brückengleichrichter, als PFC-Gleichrichter (Gleichrichter mit Leistungsfaktorkorrektur LFK - Power Factor Correction oder Power Factor Compensation PFC) ausgeführt sein. Wenn der Zwischenkreis 2 die im Prüfling gespeicherte Engergie beim Entladen nicht komplett aufnehmen kann, kann der PFC-Gleichrichter bidirektional sein.

Der Zwischenkreis 2 besteht aus einem oder mehreren Kondensatoren, die gleichgerichtete Spannung aus dem Netzgleichrichter 1 oder die in den Wechselrichter 3 rückgespeiste gleichgerichtete Spannung puffern können. Zusätzlich zu den Kondensatoren kann eine Spannungswandlung vorhanden sein, mittels der insbesondere die rückgespeiste Spannung angepasst werden kann.

Der Wechselrichter 3 kann als Wechselrichter arbeiten bei Energiefluss zum Prüfling hin und als Gleichrichter bei Energiefluss durch Rückspeisung vom Prüfling. Er kann z.B: als Halb- oder Vollbrücke ausgeführt sein und erzeugt eine rechteckförmige Wechselspannung.

Das Resonanznetzwerk 4 besteht aus einer Anordnung von induktiven und kapazitiven Elementen, die nicht sämtlich diskret ausgeführt sein müssen. Es können auch parasitäre Elemente des Transformators 5 und der nachfolgend noch beschriebenen Kaskadenanordnung genutzt werden. Beim dargestellten Ausführungsbeispiel besteht das Resonanznetzwerk 4 aus einer Serienschaltung eines Kondensators mit einer Spule (Schwingkreis), wobei die Kapazität aus der Streukapazität der Kaskadenanordnung und den Wicklungskapazitäten des Transformators 5 besteht. Bei der Auslegung des Resonanzkreises 4 sollten gemäß Obenstehendem die kapazitive Leistungsaufnahme der nachfolgenden Gleichrichterschaltung und die parasitären Kapazitäten 6 berücksichtigt werden. Diese führen zu einer Verlagerung der Resonanzfrequenz sowie einer eventuell nutzbaren Spannungsüberhöhung.

Die Hochspannungsschalter 11 bis 14 können auch passiv als Dioden geschaltet werden. Beim dargestellten Ausführungsbeispiel bestehen sie aus jeweils einer Diode je Stromrichtung, die jeweils in Reihe geschaltet sind und jeweils parallel einen Schalter haben.

Die Schaltungsanordnung hat zwei Betriebsmodi. Im Betriebsmodus a) wird die Netzspannung im Gleichrichter 1 gleichgerichtet und im Zwischenkreis 2 gespeichert. Der Gleichrichter 1 glättet die Wechselspannung und stellt eine Gleichspannung bereit. Alternativ zur Ausführung Gleichrichtung mit Zwischenkreis kann ein anderer Energiespeicher (Gleichspannung) verwendet werden. An dem Zwischenkreis 2 oder einem alternativem Energiespeicher ist ein Wechselrichter angeschlossen, der eine Rechteckspannung mit variabler Frequenz und je nach Auslegung variabler Pulsweite generiert. Das Resonanznetzwerk 4 bildet einen Filter für die Grundwelle der erzeugten Rechteckspannung. Das Übertragungsverhalten kann durch weitere diskrete Bauteile angepasst werden. Die Spannung am Transformator 5 und der Resonanzstrom sind daher annähernd sinusförmig. Der Resonanzkreis 4 stellt außerdem Blindleistung bereit und ermöglicht Nullspannungsschalten im Wechselrichter 3.

Im Betriebsmodus b) soll die Hochspannung am Prüfling abgebaut werden, also die Energie in Fig. 1 von rechts nach links fließen. Die Hochspannung vom Prüfling 15 wird in den Kondensatoren der Glättungssäule 9, 10 in Teilspannungen aufgeteilt. Werden die Hochspannungsschalter 11 und 13 sowie 12 und 14 synchron abwechselnd angesteuert, wird am Transformator eine Rechteckspannung erzeugt. Wesentlich ist die Integration des Resonanznetzwerks 4 in die Schaltungsanordnung. Diese stellt in diesem Betriebsmodus Blindleistung bereit, die es ermöglicht, in der Zeit, in der kein Schalter geschlossen ist, die Spannung am Transformator aktiv zu kommutieren (siehe Fig. 2, Intervalle I, III). Dies reduziert die Verluste in den Hochspannungsschaltern wesentlich, da die parasitären Kapazitäten der Hochspannungsschalter sowie der parasitären Erdkapazitäten nicht kurzgeschlossen werden. Durch das Resonanznetzwerk 4 ist auch der Resonanzstrom näherungsweise sinusförmig. Der Wechselrichter 3 fungiert in diesem Betriebsmodus als Gleichrichter und führt dem Zwischenkreis 2 bzw. einem anderen Energiespeicher die Energie des Prüflings zu. Vom Zwischenkreis 2 kann die Energie dann wieder dem Stromnetz mittels eines bidirektionalen PFC-Gleichrichters (PFC - power factor correction) zugeführt werden.

Durch Einstellung der Frequenz und gegebenenfalls der Pulsbreite der Ausgangsspannung des Wechselrichters 3 kann der Energiefluss vom Netz zum Prüfling geregelt werden.

Fig. 2 zeigt den Spannungsverlauf an den Punkten A, B, C in Fig. 1. Während der Intervalle II und IV ist die Spannung jeweils Maximum bzw. Minimum. Während der Intervalle I und III kommutiert die Spannung durch die im Resonanzkreis vorhandene Blindleistung.

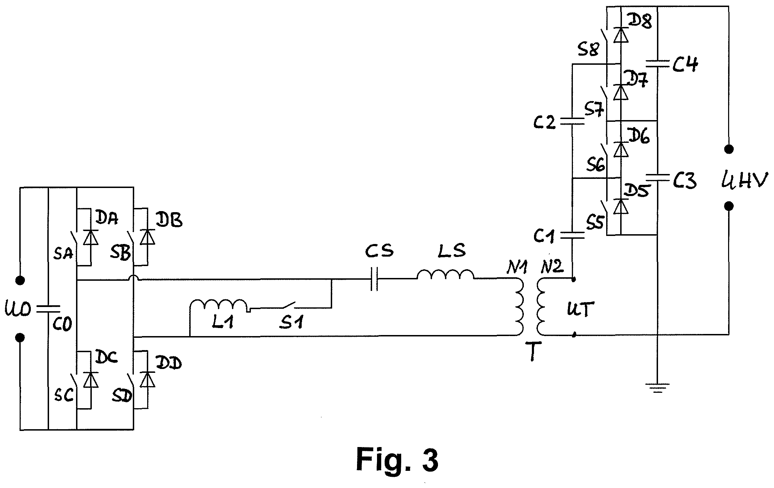

Im Folgenden wird ein Beispiel eines bei einer erfindungsgemäßen Schaltungsanordnung verwendeten Resonanzkonverters anhand von Fig. 3 mehr im Einzelnen beschrieben.

Auf der Primärseite ist ein Kondensator C0 an eine Spannungsquelle mit Eingangsspannung U0 angeschlossen, um diese zu puffern. Ebenfalls an die Spannungsquelle angeschlossen ist als Wechselrichter ein herkömmlich aufgebauter Vollbrücken-Gegentaktwandler mit je vier Leistungsschaltern SA bis SD und Dioden DA bis DD, der eine periodische Rechteckspannung erzeugt. An den Wechselrichter angeschlossen ist ein Resonanzkonverter CS, LS, N1. Parallel geschaltet ist eine Reihenschaltung eines Schalters S1 und einer Induktivität L1. An der Primärwicklung N1 des Transformators T liegt abwechselnd die Spannung +U0 und -U0 mit Mittelwert Null an. Der Transformator T kann so kleiner ausgeführt werden.

An der Sekundärwicklung N2 des Transformators T liegt entsprechend eine Hochspannung UT = N1/N2 U0 an. Eine an sie angeschlossene zweistufige Halbbrücken-Kaskadenschaltung C1 bis C4, S5 bis S8 umfasst eine Serienschaltung von zwei Kondensatoren C1 und C2, die einen die Hochspannung UT gleichmäßig auf die beiden Stufen S5, S6, C3 und S7, S8 und C4 verteilenden Spannungsteiler bilden. Die Kaskadenschaltung hat Gleichrichter- und auch Filterfunktion und dient außerdem als Spannungsvervielfacher. Je nach der benötigten Höhe der Prüfspannung kann die Kaskadenschaltung mit mehr Stufen ausgelegt werden. Die magnetische Kopplung der Induktivitäten ist bei dieser Schaltungsanordnung unkritisch. Die Streuinduktivität des Transformators T wird Bestandteil des Resonanznetzwerks und hat deshalb keine störenden Auswirkungen. Die Leistungsschalter und Dioden müssen nur für die Größe der Eingangsspannung ausgelegt werden, wobei ihre Isolationsspannung einen Bruchteil der Eingangsspannung UHV beträgt.

Bei der beschriebenen Schaltungsanordnung wird dem Transformator ein Rechteckstrom bzw. eine Rechteckspannung zugeführt, wobei eine positive und auch eine negative Spannung gewandelt werden kann.

Vorteilhaft werden als Schalter MOSFETs, IGBTs oder andere Schaltbauteile verwendet. Wenn das Gleichrichterschaltungsmittel durch die gleiche Anordnung der Primärseite des Transformators T ersetzt wird, ergibt sich eine praktisch seitengleiche Topologie. Dann kann auf der Primärseite oder auf der Sekundärseite des Transformators getaktet werden und die Energie entsprechend auf die jeweils andere Seite transportiert werden.

Die Induktivität auf der Primärseite des Transformators kann beim Rückspeisen hinzugeschaltet werden, damit die induktive Blindleistung für das Nullspannungsschalten bereitgestellt werden kann.

Fig. 3 zeigt nur die Konfiguration für positive Hochspannung.

Für bipolaren Betrieb muss die Kaskade doppelt soviele Schalter in Reihe mit jeweils anders gepolten Dioden haben.

## Patentansprüche

1. Schaltungsanordnung zur Erzeugung einer Prüfspannung für die Prüfung elektrischer Betriebsmittel, umfassend
eine Wechselspannungsquelle oder eine Spannungsquelle mit konstanter oder im wesentlichen konstanter Spannung (U0) sowie einem Schaltungsmittel zur Erzeugung einer vorzugsweise niederfrequenten Wechselspannung,
einen vorzugsweise als Resonanznetzwerk ausgeführten, mit der Wechselspannungsquelle (U0) verbundenen Wechselrichter,
eine mit dem Wechselrichter verbundene Transformatoreinrichtung (T) zur Erzeugung einer Hochspannung (UT),
ein insbesondere kaskadiert und/oder mehrstufig ausgeführtes Gleichrichterschaltungsmittel (C1 bis C4, S5 bis S8) zur Umwandlung der Hochspannung (UT) in eine Gleichspannung (UHV) veränderbarer Amplitude,
eine Schaltungseinrichtung zum Aufladen des Prüflings mit der Gleichspannung (UHV) und zum Entladen des Prüflings,
**dadurch gekennzeichnet, dass**
der Ausgang des Wechselrichters mit der Schaltungseinrichtung zum Aufladen und Entladen des Prüflings verbunden ist,
wobei der Wechselrichter auf der Eingangsseite mit (n) Schaltelementen (SA bis SD) ausgeführt ist sowie auf der Ausgangsseite mehrere (k) Stufen umfasst, und
das Gleichrichterschaltungsmittel (C1 bis C4, S5 bis S8) als Wechselrichterschaltung für das Entladen des Prüflings (15) kombiniert ausgeführt ist, deren Schalter auch als Ventile schaltbar sind, die den Stromfluss nur in eine Richtung ermöglichen.

2. Schaltungsanordnung nach Anspruch 1, **dadurch gekennzeichnet, daß** die ausgangsseitigen Stufen des Wechselrichters mit einer aktiven Spannungsbegrenzung (R3) versehen sind.

3. Schaltungsanordnung nach Anspruch 1 oder 2, **dadurch gekennzeichnet, dass** die ausgangsseitigen Stufen des Wechselrichters mit einem Überspannungsschutz versehen sind.

4. Schaltungsanordnung nach einem der Ansprüche 1 bis 3, **dadurch gekennzeichnet, dass** die ausgangsseitigen Stufen des Wechselrichters symmetriert ausgeführt sind.

5. Schaltungsanordnung nach einem der Ansprüche 1 bis 4, **dadurch gekennzeichnet, dass** die ausgangsseitigen Stufen des Wechselrichters eine Lichtsteuerung aufweisen.

6. Schaltungsanordnung nach einem der Ansprüche 1 bis 4, **dadurch gekennzeichnet, dass** eine induktive Ansteuerung für die ausgangsseitigen Stufen des Wechselrichters vorgesehen ist.

7. Schaltungsanordnung nach einem der Ansprüche 1 bis 6, **dadurch gekennzeichnet, dass** jeweils ein Schalter für eine der ausgangsseitigen k Stufen des Wechselrichters k-stufig ausgeführt ist, wobei für jeden Schalter 2k Ansteuerungen vorgesehen sind.

8. Schaltungsanordnung nach einem der Ansprüche 1 bis 7, **dadurch gekennzeichnet, dass** das Resonanznetzwerk (3) einen LLC-Resonanzkreis umfasst.

9. Schaltungsanordnung nach einem der Ansprüche 1 bis 7, **dadurch gekennzeichnet, dass** das Resonanznetzwerk (3) einen LCC-Resonanzkreis umfasst.

10. Schaltungsanordnung nach Anspruch 8 und 9, **dadurch gekennzeichnet, dass** ein Schalter zur Auswahl des LCC- oder des LLC-Resonanzkreises vorgesehen ist, wobei der LCC-Resonanzkreis für das Aufladen und der LLC-Resonanzkreis für das Rückspeisen vorgesehen sind.

## Claims

1. Circuit arrangement for generating a test voltage for testing electrical operating means, comprising
an alternating voltage source or a voltage source with a constant or substantially constant voltage (U0) and with a circuit means for generating a preferably low-frequency alternating voltage,
an inverter connected to the alternating voltage source (U0), and preferably designed as a resonant network,
a transformer device (T) connected to the inverter for generating a high voltage (UT),
a rectifier circuit means (C1 to C4, S5 to S8), designed in particular in a cascaded and/or multi-step manner, for conversion of the high voltage (UT) into a direct voltage (UHV) of variable amplitude,
a circuit device for charging the test subject with the direct voltage (UHV) and for discharging the test subject,
**characterised in that**
the output of the inverter is connected to the circuit device for charging and discharging the test subject,
wherein, on the input side, the inverter is designed with (n) switching elements (SA to SD), and on the output side the inverter comprises a plurality (k) of steps, and
the rectifier circuit means (C1 to C4, S5 to S8) is designed in a combined manner as an inverter circuit for discharging the test subject (15), the switches of which can also be switched as valves which permit the flow of current in only one direction.

2. Circuit arrangement according to claim 1, **characterised in that** the output-side steps of the inverter are provided with an active voltage limitation (R3).

3. Circuit arrangement according to claim 1 or 2, **characterised in that** the output-side steps of the inverter are provided with an over-voltage protection.

4. Circuit arrangement according to one of claims 1 to 3, **characterised in that** the output-side steps of the inverter are of balanced design.

5. Circuit arrangement according to one of claims 1 to 4, **characterised in that** the output-side steps of the inverter comprise a light control.

6. Circuit arrangement according to one of claims 1 to 4, **characterised in that** an inductive drive is provided for the output-side steps of the inverter.

7. Circuit arrangement according to one of claims 1 to 6, **characterised in that** a switch for one of the output-side k steps of the inverter is designed with k steps in each case, wherein for each switch 2 k drives are provided.

8. Circuit arrangement according to one of claims 1 to 7, **characterised in that** the resonant network (3) comprises an LLC resonant circuit.

9. Circuit arrangement according to one of claims 1 to 7, **characterised in that** the resonant network (3) comprises an LCC resonant circuit.

10. Circuit arrangement according to claim 8 and 9, **characterised in that** a switch is provided for selecting the LCC or the LLC resonant circuit, wherein the LCC resonant circuit is provided for charging purposes and the LLC resonant circuit is provided for feedback purposes.

## Revendications

1. Ensemble de circuits pour générer une tension d'essai pour l'essai de matériel électrique, comprenant
une source de tension alternative ou une source de tension avec une tension (U0) constante ou sensiblement constante ainsi qu'un moyen de commutation pour générer une tension alternative de préférence à basse fréquence,
un onduleur réalisé de préférence sous la forme d'un convertisseur à résonance et relié à la source de tension alternative (U0),
un dispositif transformateur (T), relié à l'onduleur, pour générer une haute tension (UT),
un moyen formant circuit redresseur (C1 à C4, S5 à S8) en particulier en cascade et/ou à plusieurs étages pour la conversion de la haute tension (UT) en tension continue (UHV) d'amplitude variable,
un dispositif de commutation pour charger l'objet de l'essai en tension continue (UHV) et décharger l'objet de l'essai,
**caractérisé en ce que**
la sortie de l'onduleur est reliée au dispositif de commutation pour charger et décharger l'objet de l'essai,
dans lequel l'onduleur comporte (n) éléments de commutation (SA à SD) sur le côté d'entrée ainsi que plusieurs (k) étages sur le côté de sortie, et
le moyen formant circuit redresseur (C1 à C4, S5 à S8), pour la décharge de l'objet de l'essai (15), est réalisé de manière combinée sous la forme d'un circuit onduleur dont les commutateurs peuvent également être commutés en tant que valves ne permettant la circulation du courant que dans un seul sens.

2. Ensemble de circuits selon la revendication 1, **caractérisé en ce que** les étages côté sortie de l'onduleur sont pourvus d'une limitation de tension active (R3).

3. Ensemble de circuits selon la revendication 1 ou 2, **caractérisé en ce que** les étages côté sortie de l'onduleur sont pourvus d'une protection contre les surtensions.

4. Ensemble de circuits selon l'une quelconque des revendications 1 à 3, **caractérisé en ce que** les étages côté sortie de l'onduleur sont symétriques.

5. Ensemble de circuits selon l'une quelconque des revendications 1 à 4, **caractérisé en ce que** les étages côté sortie de l'onduleur présentent une commande d'éclairage.

6. Ensemble de circuits selon l'une quelconque des revendications 1 à 4, **caractérisé en ce qu'**une commande inductive pour les étages côté sortie de l'onduleur est prévue.

7. Ensemble de circuits selon l'une quelconque des revendications 1 à 6, **caractérisé en ce qu'**un commutateur pour un des k étages côté sortie de l'onduleur est dans chaque cas à k étages, 2k commandes étant prévues pour chaque commutateur.

8. Ensemble de circuits selon l'une quelconque des revendications 1 à 7, **caractérisé en ce que** le convertisseur à résonance (3) comprend un circuit résonant LLC.

9. Ensemble de circuits selon l'une quelconque des revendications 1 à 7, **caractérisé en ce que** le convertisseur à résonance (3) comprend un circuit résonant LCC.

10. Ensemble de circuits selon les revendications 8 et 9, **caractérisé en ce qu'**un commutateur servant à sélectionner le circuit résonant LCC ou LLC est prévu, dans lequel le circuit résonant LCC est destiné à la charge et le circuit résonant LLC est destiné au retour de courant.
